# EUROPÄISCHE PATENTANMELDUNG

(11) **EP 3 828 366 A1**
(43) Veröffentlichungstag der Anmeldung: **02.06.2021**
(21) Anmeldenummer: 19212279.4
(22) Anmeldetag: 28.11.2019
(51) Int. Cl.: E05B 45/08, E05B 47/00, G07C 9/00, G08B 25/00, G08B 25/08, G08B 25/10, H04W 52/02

(54) **SENSORVORRICHTUNG**

(71) Anmelder: dormakaba Schweiz AG, 8623 Wetzikon (CH)
(72) Erfinder: Diem, Livio, CH 8623 Wetzikon (CH); Wyss, Stefan, CH 8124 Maur (CH); Laib, Dominik, CH 8623 Wetzikon (CH)
(74) Vertreter: Balder IP Law, S.L.

(57) **Zusammenfassung**

Die Erfindung betrifft eine Sensorvorrichtung (1) für ein Verschlusselement (3), insbesondere eine Tür oder ein Fenster, mit einem Sensor (20), mit einer Elektrik (40) zur Stromversorgung und/oder Ansteuerung des Sensors (20), und mit einer Vorderseite (12) und einer gegenüberliegende Rückseite (13), wobei zumindest ein Teil der Rückseite (13) als Montagefläche zur Montage der Sensorvorrichtung (1) am Verschlusselement (3) ausgebildet ist, wobei die Elektrik (40) zumindest teilweise stoffschlüssig mit der Vorderseite (12) und/oder mit der Rückseite (13) verbunden ist.

## Beschreibung

Die Erfindung betrifft eine Sensorvorrichtung für ein Verschlusselement. Bei dem Verschlusselement handelt es sich insbesondere um eine Tür oder ein Fenster.

Eine vorbekannte Sensorvorrichtung zeigt WO 2016/149723 A1, dort als Vorrichtung zum Detektieren bezeichnet.

Es ist Aufgabe vorliegender Erfindung, eine Sensorvorrichtung für ein Verschlusselement, insbesondere eine Tür oder ein Fenster, bereitzustellen, die möglichst kleinbauend ist und ein zuverlässiges Erfassen zumindest eines Zustandes am Verschlusselement ermöglicht.

Die Lösung der Aufgabe erfolgt durch die Merkmale des unabhängigen Anspruchs. Die abhängigen Ansprüche haben vorteilhafte Ausgestaltungen der Erfindung zum Gegenstand.

Somit wird die Aufgabe gelöst durch eine Sensorvorrichtung für ein Verschlusselement. Bei dem Verschlusselement handelt es sich insbesondere um eine Tür oder ein Fenster. Die Sensorvorrichtung umfasst einen Sensor. Am Sensor ist eine Sensorachse definiert.

Der Sensor wiederum umfasst vorzugsweise zumindest eine Spule. Der Einfachheit halber wird im Folgenden stellenweise eine/die Spule beschrieben; dabei ist aber stets zu verstehen, dass vorzugsweise mehrere insbesondere koaxiale Spulen zur Anwendung kommen.

Die Spule weist bevorzugt zumindest eine Wicklung auf, die sich um eine Spulenachse erstreckt; wobei die Spulenachse der Sensorachse entspricht. Die Spule dient dazu, von einem Riegelelement durchdrungen zu werden. Die Spule ist also dazu ausgebildet, von einem Riegelelement durchdrungen zu werden.

Das Verschlusselement kann das Riegelelement umfassen.

Besonders bevorzugt weist der Sensor eine Durchgangsaussparung, rundum die Sensorachse, auf. Die Durchgangsaussparung ist dazu ausgebildet, von dem Riegelelement durchdrungen zu werden. Dabei bewegt sich das Riegelelement vorzugsweise parallel zur Sensorachse. Die bevorzugt verwendete Spule erstreckt sich rund um die Durchgangsaussparung.

Des Weiteren umfasst die Sensorvorrichtung eine Elektrik. Die Elektrik ist insbesondere zur Stromversorgung und/oder Ansteuerung des Sensors, insbesondere der Spule(n), ausgebildet. Vorzugsweise ist die Elektrik elektrisch leitend mit dem Sensor, insbesondere der Spule(n), verbunden. Unter "Ansteuerung des Sensors bzw. der Spule" ist zu verstehen, dass die Elektrik den Sensor, insbesondere die Spule, mit einem bestimmten Signal beaufschlagt und/oder dazu ausgebildet ist, ein im Sensor erzeugtes Signal, insbesondere in der Spule induziertes Signal, zu erfassen.

Des Weiteren ist insbesondere vorgesehen, dass die Elektrik, aus Richtung der Sensorachse, insbesondere Spulenachse, betrachtet, neben dem Sensor, insbesondere neben der Spule, angeordnet ist. So ist insbesondere vorgesehen, dass die vollständige Elektrik, aus Richtung der Sensorachse, insbesondere Spulenachse, betrachtet, neben dem Sensor, insbesondere neben der Spule, angeordnet ist. Insbesondere ist vorgesehen, dass die Sensorachse, insbesondere Spulenachse, keinen Bestandteil der Elektrik schneidet. Insbesondere ist die Elektrik somit vollständig querab der Sensorachse, insbesondere Spulenachse, angeordnet.

Die Sensorvorrichtung, insbesondere umfassend den Sensor mit Spule und die Elektrik, ist somit vorzugsweise in einer Ebene angeordnet. Dadurch ergibt sich ein sehr dünner Aufbau der gesamten Sensorvorrichtung und es ist möglich, die Sensorvorrichtung in einem Verschlusselementspalt anzuordnen.

Wie eingangs erwähnt, ist das Verschlusselement vorzugsweise eine Tür oder ein Fenster. Zwischen dem Türblatt bzw. dem Fensterblatt, allgemein als Verschlusselementblatt bezeichnet, und dem umgebenden Rahmen ist der Verschlusselementspalt ausgebildet.

Die hier vorgestellte Sensorvorrichtung ist bevorzugt dazu ausgebildet, um in diesem Verschlusselementspalt angeordnet zu werden. Hierbei ist bevorzugt das Verschlusselementblatt und der Rahmen in der Nähe der Sensorvorrichtung metallisch ausgebildet. Insbesondere befindet sich die Sensorvorrichtung dabei auf einer dem Verschlusselementspalt zugewandten Seite des Verschlusselementblattes oder des Rahmens. Die Sensorvorrichtung ist dabei so angeordnet, dass die Sensorachse mit dem Riegelelement und der zugehörigen Öffnung fluchtet. Besonders bevorzugt ist die Sensorvorrichtung dabei verschlusselementblattseitig (insbesondere türblattseitig bzw. fensterblattseitig) angeordnet.

Am Beispiel der Tür ist insbesondere vorgesehen, dass im Türblatt ein Einsteckschloss angeordnet ist. In Richtung des Verschlusselementspalts schließt das Einsteckschloss mit dem Stulp ab. Auf der gegenüberliegenden Seite, im Rahmen montiert oder als integraler Bestandsteil des Rahmens, befindet sich das Schließblech. Aus dem Stulp heraus kann sich ein Riegelelement erstrecken. Dieses Riegelelement erstreckt sich durch den Verschlusselementspalt hindurch entlang der Sensorachse bis in eine entsprechende Öffnung im Schließblech. Dieses Riegelelement ist insbesondere ein Riegel oder eine Falle. Beim Fenster gibt es entsprechende Elemente, die sich durch den Verschlusselementspalt hindurch bis in eine entsprechende Öffnung des Rahmens erstrecken können.

Die hier vorgestellte Sensorvorrichtung ist bevorzugt dazu ausgebildet, um in diesem Verschlusselementspalt angeordnet zu werden. Insbesondere befindet sich die Sensorvorrichtung dabei auf einer dem Verschlusselementspalt zugewandten Seite des Verschlusselementblattes (insbesondere des Stulpes) oder des Rahmens (insbesondere des Schließblechs). Die Sensorvorrichtung ist dabei so angeordnet, dass die Sensorachse mit dem Riegelelement und der zugehörigen Öffnung fluchtet. Besonders bevorzugt ist die Sensorvorrichtung dabei verschlusselementblattseitig (insbesondere türblattseitig bzw. fensterblattseitig) angeordnet.

Insbesondere für diese Anordnung im Verschlusselementspalt ist bevorzugt vorgesehen, dass die einzelnen Elemente (Sensor und Elektrik) nicht nur in einer Ebene, sondern auch in einer Reihe angeordnet sind. Hierzu ist eine Raumrichtung definiert. Die Raumrichtung ist durch eine Gerade vorgegeben, die quer durch die Sensorachse, insbesondere Spulenachse, verläuft. Die Raumrichtung erstreckt sich von der Sensorachse radial nach außen. Die Elektrik schließt sich entlang dieser Raumrichtung an den Sensor an. Insbesondere schneidet diese Raumrichtung die Elektrik. Am Schnittpunkt der Raumrichtung mit der Sensorachse kann eine dritte imaginäre Achse definiert werden. Diese dritte imaginäre Achse steht senkrecht zur Sensorachse und senkrecht zur Raumrichtung. Diese dritte imaginäre Achse schneidet insbesondere nicht die Elektrik.

Die Elektrik umfasst vorzugsweise eine Elektronik. Die Elektronik umfasst insbesondere eine Sende- und Empfangseinheit und/oder einen Prozessor. Insbesondere ist die Elektronik aus mehreren Elektronikbauteilen zusammengesetzt. Die Elektronikbauteile können sich in einer Vergussmasse befinden. Die Elektronikbauteile können teilweise über diese Vergussmasse hinausragen. Insbesondere bildet diese Einheit aus mehreren Elektronikbauteilen die "Elektronik". Die Elektronik ist insbesondere zum Ansteuern des Sensors ausgebildet. Die Sende- und/oder Empfangseinheit ist bevorzugt für eine kabellose Nahbereichskommunikation, z. B. Bluetooth Low Energie oder NFC, ausgebildet.

Des Weiteren ist bevorzugt vorgesehen, dass die Elektrik zumindest einen Energiespeicherkontakt zur elektrischen Kontaktierung eines Energiespeichers umfasst. Der Energiespeicher ist insbesondere eine Batterie. Besonders bevorzugt handelt es sich hierbei um eine Knopfzelle. Durch den Energiespeicher kann auf einen Anschluss auf eine externe Energieversorgung verzichtet werden. Somit ist die Sensorvorrichtung leicht zu installieren. Die Sensorvorrichtung umfassen den Energiespeicher.

Der Energiespeicher ist vorzugsweise reversibel lösbar von der Elektrik angeordnet. Die Elektrik umfasst bevorzugt einen ersten und einen zweiten Energiespeicherkontakt. Ein erster Energiespeicherkontakt dient zur elektrischen Kontaktierung eines ersten Pols des Energiespeichers. Ein zweiter Energiespeicherkontakt dient zur elektrischen Kontaktierung eines zweiten Pols des Energiespeichers. Im Betrieb ist der Energiespeicher in der Sensorvorrichtung eingesetzt und liegt mit den Polen an den Energiespeicherkontakten an.

Besonders bevorzugt ist vorgesehen, dass sich die gesamte Elektrik lediglich auf einer Seite des Sensors anschließt.

Somit kann die Sensorvorrichtung in zumindest drei nebeneinander angeordnete Bereiche umfassen, einen Sensorbereich mit dem Sensor, einen Elektronikbereich mit der Elektronik und einen Speicherbereich mit dem Energiespeicher und den Energiespeicherkontakten.

Insbesondere befindet sich dabei die Elektronik zwischen dem/den Energiespeicher(n) und dem Sensor. Im Gesamten ergibt sich somit entlang der oben definierten Raumrichtung eine Aneinanderreihung des Sensors mit anschließender Elektronik und abschließendem/n Energiespeicher(n).

Die Anordnung der Elektronik zwischen Sensor und Energiespeicher ermöglicht relativ kurze Leitungswege, da der Energiespeicher zunächst die Elektronik und die Elektronik dann wiederum den Sensor, insbesondere die Spule, bestromt.

Die Elektronik ist insbesondere zu Ansteuerung des Sensors ausgebildet. Bei Verwendung von einer Spule bzw. mehreren Spulen erfolgt dabei die Ansteuerung der zumindest einen Spule, vorzugsweise aller Spulen. Dabei erfolgt insbesondere ein Beaufschlagen der Spule(n) mit einem Signal und oder ein Abnehmen eines Signals an der/den Spulen(n).

Die Elektronik wiederum kann durch eine übergeordnete Recheneinheit angesteuert werden. Ferner kann die Elektronik Berechnungen/Auswertungen an die übergeordnete Recheneinheit auslagern. Die Recheneinheit befindet sind insbesondere außerhalb der Sensorvorrichtung und ist, vorzugsweise kabellos, zur Datenübertragung mit der Elektronik verbunden.

Im Folgenden wird die Funktionsweise der Sensorvorrichtung am Beispiel einer Tür beschrieben. Allerdings ergibt sich selbige Funktionsweise bei der Anwendung an einem Fenster oder sonstigem Verschlusselemente. WO 2016/149723 A1 beschreibt einen Sensor und dessen Verwendung. Der gemäß vorliegender Erfindung verwendete Sensor kann gleich oder ähnlich ausgestaltet sein. Entsprechend kann insbesondere die Ansteuerung der Spule(n) aus WO 2016/149723 A1 auch für vorliegende Erfindung genutzt werden.

Wie bereits in WO 2016/149723 A1 beschrieben, wurde festgestellt, dass sich elektrische Messwerte an der zumindest einen Spule sowohl durch den Zustand des Riegelelements (in WO 2016/149723 A1 als Verriegelungselement bezeichnet) als auch in geringem Ausmaß durch den Türzustand ändern. Allein durch die elektrische Messung mittels des Sensors kann somit auf den Zustand des Riegelelements und auch auf den Türzustand geschlossen werden, ohne dass zusätzliche Taster oder Veränderungen am Riegelelement notwendig wären. Da die Spulenachse so angeordnet wird, dass die zumindest eine Spule vom Riegelelement durchdrungen werden kann, ist es möglich, mittels der Spule zu erfassen, ob sich nun das Riegelelement durch die Spule hindurch erstreckt oder nicht. Hierzu ist das Riegelelement selbstverständlich zumindest teilweise aus Metall. Bei Anordnung der Sensorvorrichtung am Stulp kann mittels des Sensors erfasst werden, ob sich das metallene Schließblech in der Nähe der Spule befindet und somit die Tür geschlossen ist oder nicht. Bei Anordnung der Sensorvorrichtung am Schließblech kann mittels der Spule erfasst werden, ob der metallene Stulp bzw. das metallene Schloss sich in der Nähe der Spule befindet und somit die Tür geschlossen ist oder nicht.

Wenn eine möglichst geringe Bauhöhe durch die Spule(n) erreicht werden soll, ist es zweckmäßig, die Elektronik (Messvorrichtung in WO 2016/149723 A1) so auszubilden, dass sie zur Messung der Impedanz der Spule geeignet ist, während diese mit einem Wechselspannungssignal oder einem Wechselstromsignal beaufschlagt wird. Dabei kann der Sensor mit nur einer Spule ausgestattet werden, wodurch sich eine möglichst geringe Dicke der Sensorvorrichtung ergibt. Gemäß wurde in WO 2016/149273 A1 nämlich beschrieben, dass sich die Impedanz der Spule verändert, wenn das Riegelelement ein- bzw. ausgefahren wird und in geringem Ausmaß, wenn das Schließblech (durch Schließen der Türe) in den Bereich der Spule kommt. Die Impedanz der Spule kann mit vorgegebenen Werten verglichen werden.

Die Zuverlässigkeit der Bestimmung des Zustandes des Riegelelements und des Türblatts kann deutlich erhöht werden, indem mittels der Elektrik an die Spule nacheinander Signale unterschiedlicher Frequenz angelegt werden. Die Impedanz wird dann bei diesen unterschiedlichen Frequenzen bestimmt und diese mit vorgegebenen Werten verglichen. Wenn z. B. bei drei Frequenzen gemessen wird und von jeder Messung auf den Zustand des Riegelelements und ggf. auf den Türzustand geschlossen wird, kann bei unterschiedlichen Ergebnissen eine Mehrheitsentscheidung gefällt werden. Andererseits ist es auch oft möglich, dass zwei Zustände bei einer bestimmten Frequenz sehr ähnliche Messwerte liefern und somit kaum unterschieden werden können, sodass allein aus diesem Grund eine Messung bei verschiedenen Frequenzen angezeigt ist.

Wenn bei mehreren Frequenzen gemessen wird, erhöht sich folglich der Stromverbrauch, verglichen mit einer einzigen Messung. So kann es zweckmäßig sein, den Sensor mit zumindest zwei Spulen auszustatten. Die zumindest zwei Spulen sind dabei bevorzugt koaxial zueinander. Dabei handelt es sich um eine Sendespule und eine Empfangsspule. Die Sendespule wird mit Wechselstrom beaufschlagt. In der Empfangsspule wird die dabei induzierte Spannung erfasst. Die induzierte Spannung in der Empfangsspule ändert sich nämlich deutlicher als die Impedanz, insbesondere bei Änderung des Türzustandes. Auf diese Weise können Messungen bei verschiedenen Frequenzen vermieden werden, wodurch der Stromverbrauch minimiert werden kann.

Die Zuverlässigkeit kann noch weiter gesteigert werden, wenn eine weitere Empfangsspule vorgesehen ist, sodass an beiden Seiten der zumindest einen Sendespule jeweils eine Empfangsspule angeordnet ist. Mittels der Elektronik wird die Differenz der in den beiden Empfangsspulen induzierten Spannung erfasst, während die zumindest eine Sendespule mit Wechselstrom beaufschlagt ist.

Folglich ist bevorzugt vorgesehen, dass der Sensor zumindest drei Spulen oder vier Spulen umfasst. Bei der bevorzugten Ausgestaltung des Sensors mit zumindest drei Spulen werden diese zumindest drei Spulen in Richtung der Spulenachse übereinander angeordnet, sodass sich eine Art Transformator ergibt. Die Spulen können dabei koaxial angeordnet sein. Die zumindest eine Sendespule befindet sich dabei insbesondere symmetrisch zwischen den beiden Empfangsspulen. Wenn sich nun ein Eisenkern (das Riegelelement) genau symmetrisch in dieser Anordnung befindet, wird in den beiden Empfangsspulen genau die gleiche Spannung induziert, die Differenzspannung zwischen den beiden Empfangsspulen ist daher 0. Wenn sich aber der Eisenkern in die eine oder andere Richtung verschiebt, wird die Anordnung asymmetrisch und es ergibt sich eine induzierte Differenzspannung an den beiden Empfangsspulen. Es ist denkbar, eine Sendespule zwischen Empfangsspulen anzuordnen. Des Weiteren ist es auch möglich, zumindest zwei Sendespulen zwischen Empfangsspulen anzuordnen. Dabei sind die Sendespulen insbesondere Teil eines gemeinsamen Stromkreises. Die Sendespulen können ein gemeinsames Signal aussenden. Ebenso können die Empfangsspulen Teil eines gemeinsamen Stromkreises sein. Daher kann auch von einer Sendespule mit zumindest zwei Wicklungsbereichen und/oder einer Empfangsspule mit zumindest zwei Wicklungsbereichen gesprochen werden.

Der Sensor kann, unabhängig von der Anzahl der Spulen, die Türzustände offen und geschlossen sowie die Riegelelementzustände eingefahren und ausgefahren erfassen. Dabei erfolgt mit der Elektronik zumindest das Bestromen der Spule und oder das untermittelbare Erfassen der Impedanz bzw. induzierten Spannung. Die weiteren Auswertungen, beispielsweise der Vergleich mit hinterlegten Werten kann ebenfalls in der Elektronik oder in der übergeordneten Recheneinheit erfolgen.

An der Sensorvorrichtung sind eine Vorderseite und eine Rückseite definiert. Die Rückseite dient als Montagefläche zur Montage der Sensorvorrichtung an dem Verschlusselement. Die Vorderseite kann auch als Vorderfläche bezeichnet werden.

Erfindungsgemäß ist die Elektrik zumindest teilweise stoffschlüssig mit der Vorderseite verbunden. Zusätzlich oder alternativ ist die Elektrik zumindest teilweise stoffschlüssig mit der Rückseite verbunden.

Dadurch, dass die Elektrik stoffschlüssig mit der Vorder- und/oder Rückseite verbunden ist, ist ein besonders kompakter Aufbau realisiert. Hierdurch kann die Sensorvorrichtung besonders kleinbauend ausgebildet sein.

Bei der Elektrik, die stoffschlüssig mit der Vorder- und/oder Rückseite verbunden ist, kann es sich insbesondere um die Sende- und/oder Empfangseinheit, den Prozessor und zumindest einen Energiespeicherkontakt handeln. Bevorzugt ist der Energiespeicher selber nicht stoffschlüssig mit der Vorder- und/oder Rückseite verbunden. Vielmehr ist der Energiespeicher reversibel lösbar in der Sensorvorrichtung angeordnet.

Die Sensorvorrichtung kann ein Gehäuse umfassen. Das Gehäuse kann zumindest ein rückseitiges Gehäuseteil und ein vorderseitiges Gehäuseteil umfassen. Das rückseitige Gehäuseteil umfasst die Rückseite. Das vorderseitge Gehäuseteil umfasst die Vorderseite. Das vorderseitige und das rückseitige Gehäuseteil sind bevorzugt reversibel voneinander lösbar, insbesondere formschlüssig miteinander verbunden, so dass das Gehäuse öffenbar ist.

Bevorzugt ist der Energiespeicher in dem Gehäuse angeordnet. Vorzugsweise umfasst die Sensorvorrichtung zumindest im Speicherbereich das Gehäuse. Das Gehäuse kann geöffnet werden, um den Energiespeicher auszutauschen. Der Energiespeicher ist bevorzugt reversibel lösbar in oder an dem rückseitigen Gehäuseteil und/oder in oder an dem vorderseitigen Gehäuseteil angeordnet.

Insbesondere bildet das Gehäuse der Sensorvorrichtung die Vorderseite und Rückseite, wobei insbesondere vorgesehen ist, dass das Gehäuse zumindest teilweise eine/mehrere Platine(n) und/oder einen Deckel und/oder ein Haltelement umfasst.

Die Vorderseite zeigt im montierten Zustand in den Verschlusselementspalt. Die Rückseite bildet eine Montagefläche, die zur Auflage am Verschlusselementblatt (insb. Stulp) oder Rahmen (insb. Schließblech) ausgebildet ist. Die entsprechende Fläche, insbesondere am Stulp oder Schließblech, zur Aufnahme der Sensorvorrichtung wird als "Auflagefläche" bezeichnet. Vorzugsweise ist die gesamte Rückseite als ebene Fläche ausgebildet und kann somit als Montagefläche, insbesondere zum Ankleben auf der Auflagefläche, verwendet werden.

Es kann sein, dass die Rückseite von einem Befestigungselement, insbesondere von einem Klebeelement gebildet ist. Mittels des Klebeelements kann die Sensorvorrichtung an dem Verschlusselement befestigt, insbesondere angeklebt, werden.

Insbesondere weist die Sensorvorrichtung, vorzugsweise an der höchsten bzw. dicksten Stellen, eine Höhe von höchstens 2,5 mm, bevorzugt höchstens 2,3 mm, besonders bevorzugt höchstens 2,1 mm, auf. Die geringst mögliche Höhe ergibt sich aus dem technisch Möglichen. Beispielsweise kann die Sensorvorrichtung eine Höhe von zumindest 1,8 mm, bevorzugt zumindest 1,5 mm, besonders bevorzugt zumindest 1,2 mm aufweisen.

Im Folgenden werden unterschiedliche Platinenteile beschrieben. Die Platinenteile können eigenständige Platinen oder auch nur Abschnitte einer größeren Platine sein. Als Platine wird insbesondere eine Leiterplatte mit deren Leiterbahnen bezeichnet. Bevorzugt handelt es sich hierbei um harte bzw. steife Platinen. Die Platine(n) können zumindest in bevorzugten Ausgestaltungen, auch als Gehäusebauteile verwendet werden. Auf und/oder in den Platinenteilen befinden sich Leiterbahnen.

So umfasst die Sensorvorrichtung vorzugsweise ein Elektronikplatinenteil. Die Elektronik ist auf diesem Elektronikplatinenteil angeordnet, bevorzugt stoffschlüssig und/oder elektrisch leitend befestigt. Die Elektronik umfasst, wie bereits beschrieben, vorzugsweise mehrere Elektronikbauteile. Diese Elektronikbauteile können sich in einer Vergussmasse befinden. Diese Vergussmasse bildet dann eine entsprechende Schicht auf dem Elektronikplatinenteil. Eine Antenne der Sende- und/oder Empfangseinheit kann Teil des Elektronikplatinenteils sein.

Die Sensorvorrichtung umfasst vorzugsweise ein Sensorplatinenteil. Das Sensorplatinenteil umfasst den Sensor. Wie bereits beschrieben, umfasst der Sensor vorzugsweise zumindest eine Spule. Diese Spule befindet sich auf der Platte des Sensorplatinenteil oder im Inneren des Sensorplatinenteils. Die zumindest eine Spule kann als Leiterbahn des Sensorplatinenteils ausgebildet sein. Alle Spulen des Sensors können als Leiterbahnen des Sensorplatinenteils ausgebildet sein. So kann die zumindest eine Spule insbesondere durch Leiterbahnen des Sensorplatinenteils gebildet sein, die in dem Sensorplatinenteil oder auf der Platte des Sensorplatinenteils ausgebildet sind. Umfasst der Sensor mehrere Spulen, so sind die Spulen bevorzugt zumindest teilweise innerhalb des Sensorplatinenteils in Richtung der Sensorachse übereinander angeordnet. Bevorzugt sind alle Spulen als Teil des Sensorplatinenteils in Richtung der Spulenachse übereinander angeordnet.

Ferner umfasst die Sensorvorrichtung vorzugsweise ein Speicherplatinenteil. Das Speicherplatinenteil ist zumindest zur Kontaktierung des/der Energiespeicher(s) ausgebildet. Hierzu umfasst das Speicherplatinenteil vorzugsweise zumindest einen Energiespeicherkontakt. Der Energiespeicherkontakt ist insbesondere auf dem Speicherplatinenteil angeordnet. Besonders bevorzugt befinden sich der erste und der zweite Energiespeicherkontakt auf dem Speicherplatinenteil. Besonders bevorzugt befindet/befinden sich auch der/die Energiespeicher unmittelbar auf dem Speicherplatinenteil.

Der Energiespeicherkontakt ist insbesondere ein auf der Speicherplatine aufgesetztes Blechbauteil, das entsprechend mit einer Leiterbahn auf bzw. im Speicherplatinenteil elektrisch leitend verbunden ist. Besonders bevorzugt befindet/befinden sich auch der/die Energiespeicher unmittelbar auf dem Speicherplatinenteil und dabei in Kontakt mit dem/den Energiespeicherkontakt(en).

Alternativ oder zusätzlich kann der Energiespeicherkontakt unmittelbar an der Oberfläche des Speicherplatinenteils ausgebildet sein. Bevorzugt umfasst die Sensorvorrichtung ein federndes Element und/oder einen Vorsprung, das den Energiespeicher gegen den Energiespeicherkontakt drückt.

Es kann sein, dass das Speicherplatinenteil zumindest einen Teil eines Gehäuses der Sensorvorrichtung bildet. Insbesondere umfasst das rückseitige oder das vorderseitige Gehäuseteil das Speicherplatinenteil. Das Speicherplatinenteil ist vorzugsweise reversibel lösbar von einem weiteren Teil des Gehäuses derart ausgebildet ist, sodass der Energiespeicher austauschbar ist. Umfasst das rückseitige Gehäuseteil das Speicherplatinenteil, so ist das vorderseitige Gehäuseteil von dem Speicherplatinenteil reversibel lösbar. Umfasst das vorderseitige Gehäuseteil das Speicherplatinenteil, so ist das Speicherplatinenteil von dem rückseitigen Gehäuseteil reversibel lösbar.

Das Speicherplatinenteil weist eine Innenseite und eine Außenseite auf. Insbesondere bildet das top layer oder botton layer des Speicherplatinenteils die "Außenseite". Die Außenseite des Speicherplatinenteils kann stoffschlüssig mit der Vorder- oder der Rückseite der Sensorvorrichtung verbunden sein. In einem Ausführungsbeispiel ist das Speicherplatinenteil mit einem Klebeelement verbunden, insbesondere verklebt, wobei das Klebeelement die Rückseite der Sensorvorrichtung bildet. Das rückseitige Gehäuse kann das Speicherplatinenteil und das Klebeelement umfassen.

In einem anderen Ausführungsbeispiel bildet das Speicherplatinenteil unmittelbar die Vorderseite der Sensorvorrichtung und/oder ist mit der Vorderseite stoffschlüssig verbunden. Die Vorderseite kann durch eine auf dem Speicherplatinenteil aufgetragene Lackschicht oder durch eine auf dem Speicherplatinenteil befestigte Folie gebildet sein.

Es kann sein, dass das Elektronikplatinenteil stoffschlüssig mit einer Vorderseite und/oder einer Rückseite der Sensorvorrichtung verbunden ist. Die Elektronik kann auf einer Innenseite des Elektronikplatinenteils angeordnet sein. Die Außenseite des Elektronikplatinenteils kann stoffschlüssig mit der Vorderseite und/oder der Rückseite verbunden sein oder die Vorder- oder Rückseite bilden.

Es kann vorgesehen sein, dass das Elektronikplatinenteil einen Teil eines Gehäuseteils der Sensorvorrichtung bildet. Insbesondere weist das Elektronikplatinenteil eine Außenseite und eine Innenseite auf. Auf der Innenseite des Elektronikplatinenteils befindet sich die Elektronik, insbesondere die Elektronikbauteile. Die Außenseite des Elektronikplatinenteils bildet einen Teil des Gehäuses. Gemäß einer Variante bildet dabei diese Außenseite des Elektronikplatinenteils zumindest einen Teil eines rückseitigen Gehäuseteils der Sensorvorrichtung.

Alternativ kann vorgesehen sein, dass in dem Elektronikbereich der Sensorvorrichtung die Sensorvorrichtung gehäuselos ausgebildet ist. Somit sind in dem Elektronikbereich die Vorder- und die Rückseite der Sensorvorrichtung stoffschlüssig verbunden.

Insbesondere ist dabei vorgesehen, dass eine Seite des Sensorplatinenteils einen Teil der Vorderseite bildet oder mit der Vorderseite stoffschlüssig verbunden ist. Das Sensorplatinenteil kann zusätzlich oder alternativ einen Teil der Rückseite bildet oder mit der Rückseite stoffschlüssig verbunden ist.

Die Sensorvorrichtung umfasst vorzugweise ein Halteelement. Das Halteelement kann z. B. Seitenwände der Sensorvorrichtung bilden. Das Halteelement kann aus Kunststoff ausgebildet sein,

Das Halteelement kann einstückig mit dem Speicherplatinenteil und/oder mit dem Elektronikplatinenteil ausgebildet sein. Das Halteelement ist vorzugsweise auf oder an dem Elektronikplatinenteil und/oder dem Speicherplatinenteil zumindest mittelbar stoffschlüssig befestigt ist. Z. B. können das Halteelement und das Speicherplatinenteil auf dem Klebeelement befestigt, insbesondere angeklebt, sein. Z. B. können das Halteelement und das Elektronikplatinenteil auf dem Klebeelement befestigt, insbesondere angeklebt, sein.

Vorzugsweise ist vorgesehen, dass das Halteelement das Speicherplatinenteil und/oder Elektronikplatinenteil zumindest teilweise, insbesondere vollständig, umgibt. Z. B. kann das Halteelement als Rahmen ausgebildet sein, in dem das Speicherplatinenteil und/oder das Elektronikplatinenteil angeordnet sind.

In bevorzugter Ausgestaltung ist vorgesehen, dass das Elektronikplatinenteil und das Speicherplatinenteil einstückig ausgebildet sind und somit durch eine gemeinsame Platine gebildet sind. Auf einer Innenseite des Elektronikplatinenteils befindet sich die Elektronik, insbesondere die Elektronikbauteile. Auf einer Innenseite des Speicherplatinenteils ist der Energiespeicher reversibel anordbar. Somit können auf derselben Seite der gemeinsamen Platine die Elektronik und der Energiespeicher angeordnet sein. Auf derselben Seite der Platine können die Elektronik und zumindest ein Energiespeicherkontakt stoffschlüssig mit der Platine verbunden sein.

Die hier vorgestellten Platinenteile erstrecken sich insbesondere in einer zur Sensorachse senkrechten Ebene.

Bevorzugt ist vorgesehen, dass das Sensorplatinenteil über eine Steckverbindung mit dem Elektronikplatinenteil verbunden ist. Alternativ hierzu ist es auch möglich, dass das Elektronikplatinenteil und das Sensorplatinenteil zumindest teilweise einstückig miteinander ausgebildet sind, insbesondere durch ein flexibles Platinenteil miteinander verbunden sind. So kann das Sensorplatinenteil zumindest teilweise durch ein flexibles Platinenteil gebildet sein. Entsprechendes gilt für das Elektronikplatinenteil. Dieser flexible Abschnitt bildet dann die Verbindung zwischen Sensor und Elektronik.

Die Sensorvorrichtung umfasst vorzugweise ein Halteelement. Das Halteelement kann insbesondere neben den Platinen und dem Sockel Teile der Gehäuseoberfläche, beispielsweise auch Seitenwände, bilden.

Das Halteelement ist vorzugsweise auf oder an dem Elektronikplatinenteil und/oder dem Speicherplatinenteil stoffschlüssig befestigt ist.

Vorzugsweise ist vorgesehen, dass das Halteelement das Speicherplatinenteil und/oder Elektronikplatinenteil zumindest teilweise, insbesondere vollständig als Rahmen, umgibt.

Bevorzugt ist vorgesehen, dass die Sensorvorrichtung ein Sockelelement umfasst. Das Sockelelement ist so ausgebildet, um den Sensor, insbesondere die Spule(n), von der Rückseite bzw. der Auflagefläche, auf der die Sensorvorrichtung montiert wird, zu beabstanden.

Das Sensorplatinenteil liegt vorzugsweise auf einem Sockelelement auf. Dieses bevorzugt verwendete Sockelelement beabstandet das Sensorplatinenteil und somit insbesondere die Spule von der Rückseite bzw. Montagefläche, insbesondere dem Stulp bzw. Schließblech.

Wenn allerdings kein Sockelelement verwendet wird, ist bevorzugt vorgesehen, dass das Sensorplatinenteil die Vorderseite und/oder die Rückseite der Sensorvorrichtung bildet oder mit der Vorderseite und/oder der Rückseite stoffschlüssig verbunden ist.

Das Sockelelement kann als ein integraler Bestandteil des Halteelementes ausgebildet sein. Alternativ kann das Sockelelement stoffschlüssig mit dem Elektronikplatinenteil und/oder dem Speicherplatinenteil verbunden sein. Insbesondere kann das Sockelelement als Teil der gemeinsamen Platine ausgebildet sein.

Des Weiteren ist bevorzugt vorgesehen, dass die Vorderseite der Sensorvorrichtung, also die dem Verschlusselementspalt zugewandte Seite, eben ist.

Insbesondere ist dabei vorgesehen, dass das Sockelelement einen Höhenunterschied zwischen dem Sensorplatinenteil einerseits und dem Elektronikbereich und/oder dem Speicherbereich andererseits ausgleicht. Insbesondere kann das Sockelelement einen Höhenunterschied zwischen dem Sensorplatinenteil einerseits und einem Elektronikbereich mit dem Elektronikplatinenteil und/oder einem Speicherbereich mit dem Speicherplatinenteil andererseits ausgleichen.

Das Sensorplatinenteil und das Elektronikplatinenteil bzw. Speicherplatinenteil befinden sich auf unterschiedlichen Höhen. Das Sockelelement befindet sich im Wesentlichen in der gleichen Ebene wie das Elektronikplatinenteil bzw. Speicherplatinenteil und gleicht somit den Höhenunterschied aus. Bei dieser Variante ist insbesondere vorgesehen, dass das Elektronikplatinenteil und/oder Speicherplatinenteil mit der jeweiligen Außenseite der Rückseite (Montagefläche) der Sensorvorrichtung zugewandt sind. Die außenliegende Seite des Sockelelements ist dabei bevorzugt ebenfalls der Rückseite zugewandt.

Des Weiteren bildet das Halteelement vorzugsweise eine Elektronikaussparung. Die Elektronikaussparung kann als Durchgangsaussparung ausgebildet sein. Die Elektronik, insbesondere die Sende- und/oder Empfangseinheit und/oder der Prozessor, wird von dem Halteelement zumindest teilweise, bevorzugt vollständig seitlich, umgeben. In die Elektronikaussparung kann die Elektronik, insbesondere die Vergussmasse mit den Elektronikbauteilen ragen. Das Halteelement kann als Wanne für die Vergussmasse dienen. Die Vergussmasse kann sich in der Elektronikaussparung befinden. Insbesondere ist die Vergussmasse während der Fertigung der Sensorvorrichtung in die Elektronikaussparung gegossen worden. Die Vergussmasse kann formschlüssig mit dem Halteelement verbunden sein. Die Elektronik, insbesondere die Sende- und/oder Empfangseinheit und/oder der Prozessor, kann sich zumindest teilweise in der Vergussmasse befinden.

Alternativ ist es denkbar, die Elektronik mit einer Schutzfolie abzudecken. Die Schutzfolie kann mit dem Halteelement verbunden, insbesondere verklebt, sein. Die Schutzfolie kann eine ebene Oberfläche im Elektronikbereich bilden. Die Schutzfolie kann einstückig mit einer Folie, die den Speicherbereich abdeckt, ausgebildet sein.

Gemäß einer Variante, ist im Halteelement zumindest eine Energiespeicheraufnahme ausgebildet. Die Energiespeicheraufnahme ist bevorzugt als zumindest eine Durchgangsaussparung im Halteelement ausgebildet. In der Energiespeicheraufnahme kann der Energiespeicher eingesetzt werden. Das Speicherplatinenteil verschließt vorzugsweise die Energiespeicheraufnahme auf der einer Seite, insbesondere auf der Rückseite. Der Deckel verschließt vorzugsweise die Energiespeicheraufnahme auf der gegenüberliegenden Seite, insbesondere auf der Vorderseite.

Vorzugsweise ist zumindest ein Energiespeicherkontakt als Feder ausgebildet. Der Energiespeicherkontakt kann den Energiespeicher innerhalb der Energiespeicheraufnahme pressen. Der Energiespeicherkontakt kann den Energiespeicher gegen das Halteelement pressen. Alternativ oder zusätzlich kann der Energiespeicherkontakt das Halteelement gegen das Speicherplatinenteil und/oder gegen einen weiteren Energiespeicherkontakt pressen.

Das Gehäuse kann den Deckel umfassen. Das vorderseitige Gehäuseteil kann den Deckel umfassen. Somit kann der Deckel die Vorderseite des Gehäuses bilden oder insbesondere stoffschlüssig mit der Vorderseite verbunden sein. Der Deckel ist insbesondere reversibel lösbar von einem weiteren Gehäuseteil, insbesondere dem rückseitigen Gehäuseteil, ausgebildet.

Der Deckel kann zumindest einen Vorsprung umfassen. Der Vorsprung ist insbesondere federnd ausgebildet. Mittels des Vorsprungs kann der Energiespeicher gegen das Speicherplatinenteil gedrückt werden.

Die Vorderseite des Halteelements ist vorzugsweise mittels des Deckels verschlossen.

Insbesondere weist das Halteelement an der Vorderseite eine Halteelementkrempe auf. Diese Halteelementkrempe umgibt die Elektrik, insbesondere die Elektronikaussparung und die Energiespeicheraufnahmen. Auf die Halteelementkrempe kann der Deckel, insbesondere in einer elastischen Ausgestaltung, beispielsweise aus Silikon, aufgesteckt werden. Die Ränder des Deckels umgreifen im aufgesteckten Zustand der Halteelementkrempe.

In einer alternativen Ausgestaltung des Deckels, ist dieser senkrecht zur Sensorachse auf das Halteelement aufschiebbar. Der Deckel weist vorzugsweise eine Rastzunge auf. Im Halteelement ist vorzugsweise eine Zungenaufnahme ausgebildet. Im geschlossenen Zustand rastet die Rastzunge in die Zungenaufnahme ein.

In einer weiteren Alternative weist der Deckel ein Verbindungselement auf. Das rückseitige Gehäuseteil weist Vorsprünge auf, die bei geschlossenem Gehäuse formschlüssig mit dem Verbindungselement verbunden sind. Zum Schließen des Gehäuses kann das Verbindungselement durch Aussparungen im rückseitigen Gehäuseteil, insbesondere im Halteelement, geführt werden.

Gemäß einer weiteren Variante ist nicht das rückseitige Gehäuseteil durch das Elektronikplatinenteil und/oder Speicherplatinenteil gebildet, sondern ein vorderseitiges Platinenteil. Das rückseitige Gehäuseteil umfasst das Halteelement. Das Halteelement kann die Seitenwände bilden. Auch hier ist das Halteelement vorzugsweise einstückig mit dem optionalen Sockelelement ausgebildet. An der Vorderseite wird das Halteelement durch das Elektronikplatinenteil und das Speicherplatinenteil verschlossen. Vorzugsweise sind das Elektronikplatinenteil und/oder das Speicherplatinenteil an dem Halteelement reversibel lösbar befestigt, insbesondere sind die Platinenteile in das Halteelement (31) eingeclipst und/oder eingefahren.

Allgemein ist insbesondere für ausreichenden Bauraum des Sensors bevorzugt vorgesehen, dass ein Normalenvektor der Rückseite definiert ist, und das Halteelement im Bereich der Elektrik und im Bereich des Sensors unterschiedlich hoch in Richtung des Normalenvektors ausgebildet ist.

Das Erfassen mittels des Sensors funktioniert umso besser, je größer, bei Verwendung mehrerer Spulen, der Abstand zwischen den Spulen ist bzw. je größer der Abstand einer einzelnen Spule von der Rückseite bzw. Montagefläche ist. Die Monatefläche liegt im montierten Zustand nämlich an der Auflagefläche (z.B. Stulp oder Schließblech) auf. Die Auflagefläche ist im Regelfall aus Metall und stört somit das Messergebnis.

Vorzugsweise ist/sind in Richtung der Spulenachse zumindest eine der Spulen, vorzugsweise zumindest zwei Spulen, besonders vorzugsweise zumindest drei Spulen, besonders vorzugsweise zumindest vier Spulen, versetzt, insbesondere beabstandet, zu dem Elektronikplatinenteil und/oder zu dem Speicherplatinenteil angeordnet. "Versetzt" bedeutet, dass die Mitte der Spule zur Mitte des Platinenteils versetzt ist, und zwar in Richtung der Spulenachse. Die "Beabstandung" bedeutet folgendes: Die Spule weist eine dem Platinenteil zugewandte Seite auf. Das Platinenteil weist eine der Spule zugewandte Seite auf. Zwischen diesen beiden Seiten ist ein Abstand größer 0 vorgesehen. Hierbei muss sich das Elektronikplatinteil und/oder das Speicherplatinenteil nicht in Richtung der Spulenachse unter den Spulen befindet. Vielmehr kann das Elektronikplatinteil und/oder das Speicherplatinenteil zudem quer zu der Spulenachse versetzt ausgebildet sein.

Grundsätzlich ist im Rahmen der Erfindung vorgesehen, die Sensorvorrichtung möglichst dünn auszugestalten. Dementsprechend wird auch ein möglichst dünnes Elektronikplatinenteil verwendet. Der Abstand zwischen den Spulen bzw. der Abstand der einzelnen Spule zur Montagefläche sollte allerdings trotz der gewünschten dünnbauenden Ausgestaltung zumindest so groß gewählt werden, dass der oben beschriebene Versatz, insbesondere die Beabstandung entsteht.

Gemäß einer ersten Variante ist insbesondere vorgesehen, dass der Sensor zumindest zwei Spulen aufweist und zumindest eine Spule nicht versetzt ist und zumindest eine Spule versetzt, insbesondere beabstandet, zum Elektronikplatinenteil angeordnet ist.

Gemäß einer zweiten Variante ist insbesondere vorgesehen, dass der Sensor zumindest eine Spule, insbesondere zumindest zwei, vorzugsweise zumindest drei, besonders vorzugsweise zumindest vier, Spulen aufweist. Dabei sind vorzugsweise alle Spulen versetzt, insbesondere beabstandet, zum Elektronikplatinenteil angeordnet ist.

Insbesondere bei einer Ausgestaltung, in der der Sensor zumindest zwei Spulen aufweist, ist vorzugsweise Folgendes vorgesehen: Der Bereich, in dem sich die Spulen befinden, ist als Spulenbereich definiert. Dieser Spulenbereich ist insbesondere ist ein Bereich auf dem Sensorplatinenteil. Der Spulenbereich weist bevorzugt eine größere Höhe in Richtung der Spulenachse auf als das Elektronikplatinenteil. Die "Höhe" kann auch als "Dicke" bezeichnet werden. Besonders bevorzugt beträgt die Höhe des Spulenbereichs zumindest 110 % der Höhe des Elektronikplatinenteils.

Die Erfindung umfasst des Weiteren eine Anordnung. Die Anordnung umfasst die hier beschriebene Sensorvorrichtung und das Verschlusselement. Das Verschlusselement ist insbesondere eine Tür oder ein Fenster. Der rahmenseitige Bereich des Verschlusselements wird als Schließblech bezeichnet. Der türblatt- bzw. fensterblattseitige Bereich des Verschlusselements wird als Stulp bezeichnet. Die Anordnung umfasst ferner ein bewegliches Riegelelement, insbesondere Bestandteil eines Schlosses im Türblatt oder einer Schließmechanik im Fensterblatt. Zwischen Stulp und Schließblech ist ein Verriegelungselementspalt ausgebildet. Die Sensorvorrichtung befindet sich in dem Verriegelungselementspalt an einer Auflagefläche, sodass das Riegelelement die Spule(n) durchdringen kann.

Die Sensorvorrichtung ist dabei mit ihrer Rückseite (Montagefläche) an der Auflagefläche, vorzugsweise am Stulp, montiert, insbesondere angeklebt.

Die Sensorvorrichtung ist insbesondere so angeordnet, dass das Riegelelement beim Ein- und Ausfahren durch die Spule des Sensors und insbesondere auch durch die Durchgangsaussparung hindurch ragt.

Die Sensorvorrichtung befindet sich (bei Anordnung am Stulp) vorzugsweise außenseitig am Stulp und somit dem Schließblech zugewandt bzw. (bei Anordnung am Schließblech) vorzugsweise außenseitig am Schließblech und somit dem Stulp zugewandt. Die Sensorvorrichtung ragt somit in den Verschlusselementspalt hinein.

Die Erfindung wird nun anhand von Ausführungsbeispielen näher beschrieben. Dabei zeigen:
- Figur 1: eine erfindungsgemäße Anordnung mit erfindungsgemäßer Sensorvorrichtung gemäß allen Varianten,
- Figuren 2 - 9: die erfindungsgemäße Sensorvorrichtung gemäß einer ersten Variante,
- Figur 10: die erfindungsgemäße Sensorvorrichtung gemäß einer zweiten Variante,
- Figuren 11 - 14: die erfindungsgemäße Sensorvorrichtung gemäß einer dritten Variante und
- Figuren 15-17: die erfindungsgemäße Sensorvorrichtung gemäß einer vierten Variante.

Elemente mit derselben oder ähnlichen Funktion werden in den verschiedenen Varianten mit denselben Bezugszeichen bezeichnet.

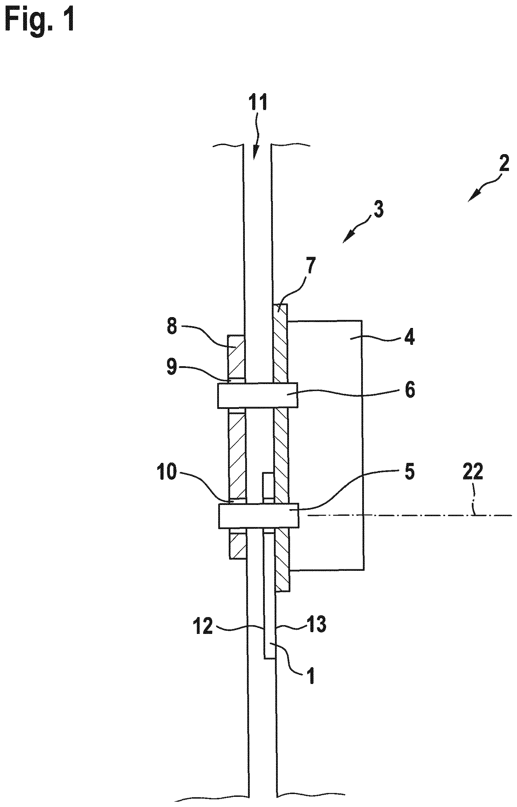

Figur 1 zeigt in rein schematischer Darstellung eine Anordnung 2. Die Anordnung 2 umfasst eine Sensorvorrichtung 1 und ein Verschlusselement 3, hier ausgebildet als Tür. Von dem Verschlusselement 3 ist lediglich ein Ausschnitt gezeigt.

Das Verschlusselement 3 umfasst ein Schloss 4 in einem Türblatt. Das Schloss 4 wiederum weist einen Stulp 7 auf. In dem Schloss 4 befindet sich ein Riegelelement 5, hier ausgebildet als Riegel. Das Riegelelement 5 ist beispielsweise mit einem Schlüssel ein- und ausfahrbar. Das Riegelelement 5 ist entlang einer Spulenachse 22 verschiebbar. Diese Spulenachse 22 ist Teil der Sensorvorrichtung 1 und wird noch im Detail erläutert.

Das Schloss 4 kann ein weiteres Riegelelement 6, beispielsweise in Form einer Falle, aufweisen. Im gezeigten Ausführungsbeispiel durchdringt das Riegelelement 5 die Sensorvorrichtung 1. Allerdings kann die Sensorvorrichtung 1 auch so ausgebildet und angeordnet werden, dass das weitere Riegelelement 6 (Falle) die Sensorvorrichtung 1 durchdringt und mittels der Sensorvorrichtung 1 erfasst wird.

Dem Türblatt liegt der Rahmen der Anordnung 2 gegenüber. In diesem Rahmen befindet sich, als separates Bauteil oder integraler Bereich, das Schließblech 8. Das Schließblech 8 weist eine Fallenöffnung 9 und eine Riegelöffnung 10 auf. In diese Riegelöffnung 10 erstreckt sich das Riegelelement 5 im ausgefahrenen Zustand. Dementsprechend erstreckt sich das weitere Riegelelement 6 in die Fallenöffnung 9.

Zwischen Stulp 7 und Schließblech 8 ist im geschlossenen Zustand des Verschlusselements ein Verschlusselementspalt 11 ausgebildet. In diesem Verschlusselementspalt 11 befindet sich die Sensorvorrichtung 1.

Die Sensorvorrichtung 1 weist eine Vorderseite 12 und eine Rückseite 13 auf. Die Vorderseite 12 und Rückseite 13 sind insbesondere senkrecht zur Spulenachse 22 definiert. Die Rückseite 13 bildet die Montagefläche der Sensorvorrichtung 1 und ist auf einer Auflagefläche am Stulp 7 befestigt, insbesondere angeklebt. Die Sensorvorrichtung 1 und somit auch die Auflagefläche können sich über den Stulp 7 hinaus erstrecken.

Die Vorderseite 12, die auch als Vorderfläche bezeichnet werden kann, ist dem Verschlusselementspalt 11 zugewandt.

In einer nicht dargestellten Variante ist es auch möglich, die Sensorvorrichtung 1 auf der anderen Seite, nämlich am Schließblech 8 entsprechend anzuordnen.

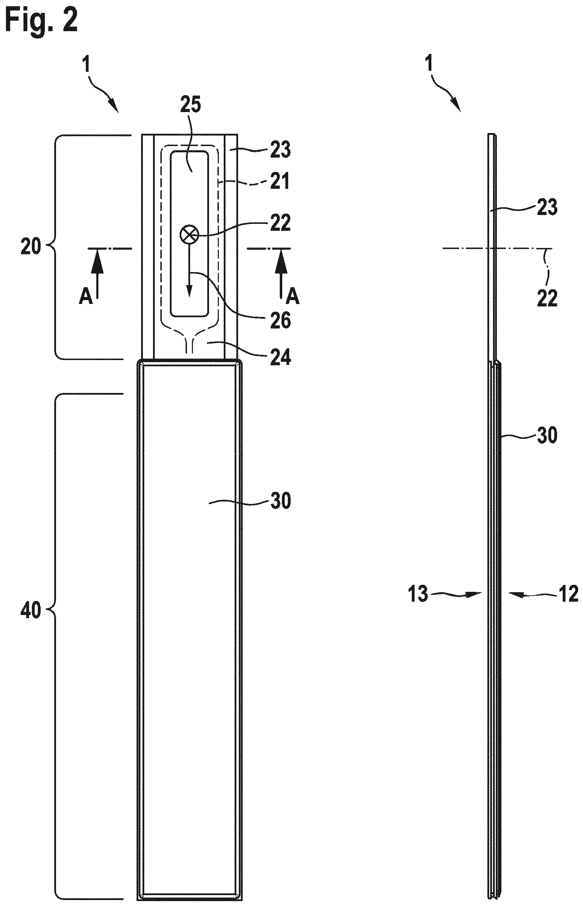

Die Figuren 2 bis 9 zeigen in unterschiedlichen Darstellungen den grundsätzlichen Aufbau der Sensorvorrichtung 1 sowie gewisse Besonderheiten der ersten Variante der Sensorvorrichtung 1.

Im Folgenden wird, soweit nicht explizit anders erwähnt, stets auf die Figuren 2 bis 9 Bezug genommen.

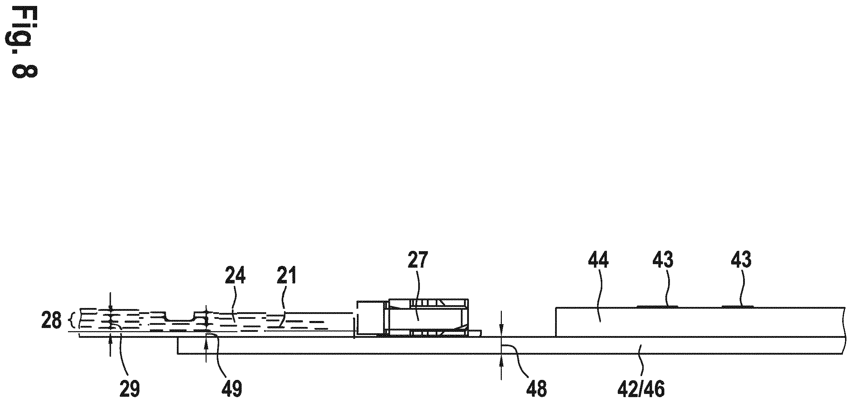

Die Sensorvorrichtung 1 umfasst einen Sensor 20. Der Sensor 20 wiederum weist zumindest eine Spule 21 auf, die hier nur rein schematisch dargestellt ist. Die Spule 21 definiert die Spulenachse 22. Insbesondere ist vorgesehen, dass die zumindest eine Spule 21 als Leiterbahn des Sensorplatinenteil 24 der Sensorvorrichtung 1 ausgebildet ist. Insbesondere ist die Spule 21 eine Leiterbahn im Sensorplatinenteil 24 oder auf der Platte des Sensorplatinenteils 24. Mehrere Spulen 21 sind als mehrere in Richtung der Spulenachse 22 übereinander angeordnete Leiterbahnen ausgebildet. Dieses ist in Figur 8 dargestellt. Hierbei ist die mittlere Spule 21 als eine Sendespule ausgebildet. Die beiden anderen Spulen 21 sind als Empfangsspulen ausgebildet. Das Sensorplatinenteil 24 liegt auf einem Sockelelement 23. Das Sockelelement 23 ist in den ersten drei Ausführungsbeispielen insbesondere aus elektrisch nichtleitendem Material, insbesondere Kunststoff gebildet.

Sowohl das Sockelelement 23 als auch die Spule 21 und das Sensorplatinenteil 24 weisen eine Durchgangsaussparung 25 auf. Durch diese Durchgangsaussparung 25 erstreckt sich die Spulenachse 22.

Die Sensorvorrichtung 1 ist in der Anordnung 2 insbesondere so angeordnet, dass sich das Riegelelement 5 durch diese Durchgangsaussparung 25 entlang der Spulenachse 22 erstrecken kann.

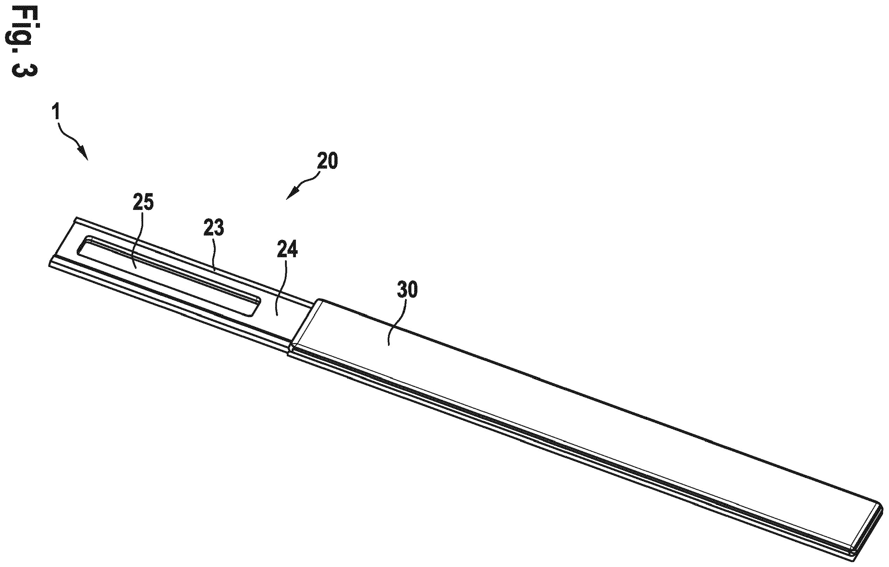

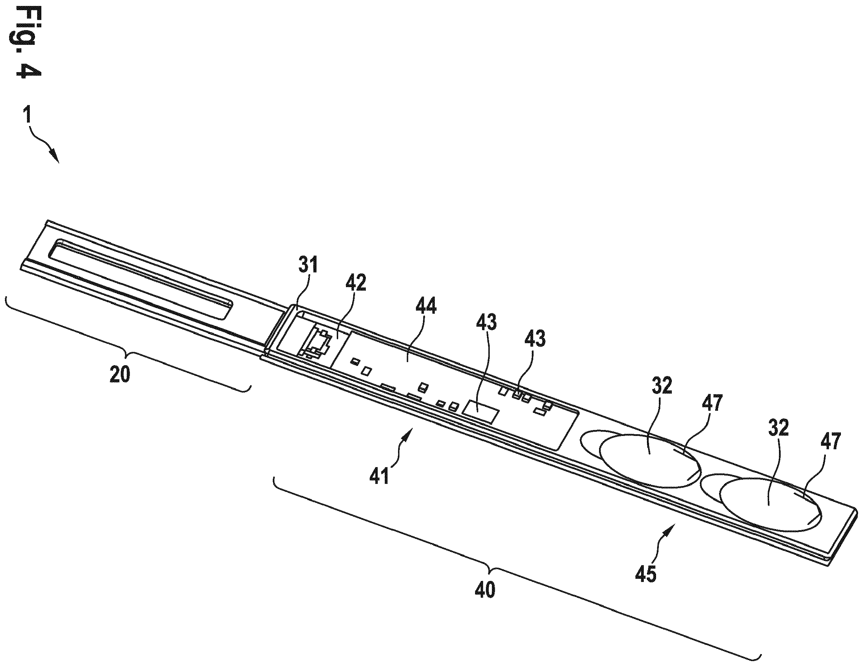

Neben dem Sensor 20 umfasst die Sensorvorrichtung 1 eine Elektrik 40. Diese Elektrik 40 ist mit einem Deckel 30 verschlossen. Figuren 2 und 3 zeigen diesen Deckel 30. In Figur 4 ist der Deckel 30 ausgeblendet.

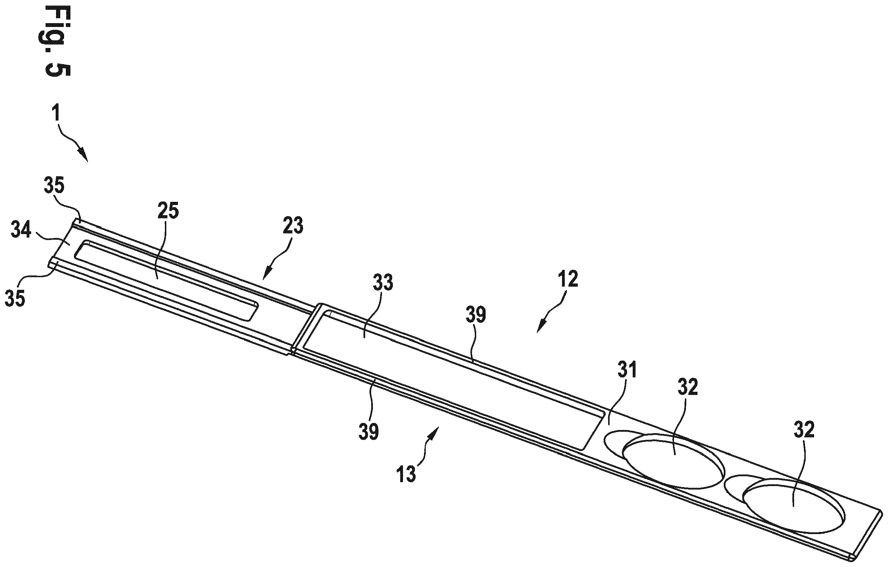

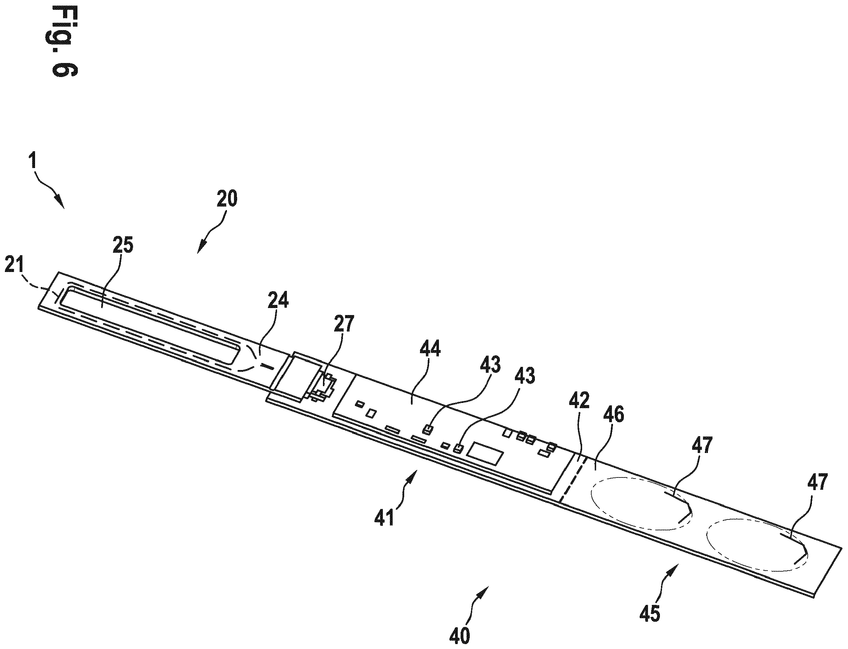

Die Sensorvorrichtung 1 umfasst ein Halteelement 31, insbesondere aus Kunststoff. Insbesondere bilden das Halteelement 31 und das Sockelelement 23 ein einstückiges Bauteil. Figur 5 zeigt das Halteelement 31 in Alleinstellung. In Figur 6 sind der Deckel 30 und das Halteelement 31 ausgeblendet.

Wie insbesondere die Figuren 4 und 6 zeigen, umfasst die Elektrik 40 eine Elektronik 41 und Energiespeicherkontakte 47 zur elektrischen Kontaktierung von zwei Energiespeicher 45. Die Energiespeicher 45 sind hier als Knopfbatterien ausgebildet.

Die Elektronik 41 setzt sich zusammen aus mehreren Elektronikbauteilen 43, die auf einem Elektronikplatinenteil 42 angeordnet sind. Die Elektronikbauteile 43 befinden sich in einer Vergussmasse 44.

Das Elektronikplatinenteil 42 ist einteilig mit einem Speicherplatinenteil 46 ausgestaltet. Lediglich der Übersichtlichkeit halber ist in Figur 6 eine gestrichelte, imaginäre Grenze zwischen Elektronikplatinenteil 42 und Speicherplatinenteil 46 eingezeichnet.

Auf dem Speicherplatinenteil 46 sind erste Energiespeicherkontakte für einen ersten Pol der Energiespeicher 45 ausgebildet (nicht dargestellt). Diese befinden sich unmittelbar auf dem Speicherplatinenteil 46.

Auf dem Speicherplatinenteil 46 befinden sich ebenfalls für die beiden Energiespeicher 45 Energiespeicherkontakte 47 zur elektrischen Kontaktierung des zweiten Pols der Energiespeicher 45.

Wie beispielsweise Figur 4 zeigt, sind im Halteelement 31 zwei Energiespeicheraufnahmen 32 ausgebildet. Die beiden Energiespeicheraufnahmen 32 sind Durchgangsaussparungen im Halteelement 31. In diese Energiespeicheraufnahmen 32 können die beiden Energiespeicher 45 eingesetzt werden und können dabei durch die ersten und zweiten Energiespeicherkontakte 47 kontaktiert werden.

Des Weiteren bildet das Haltelement eine Elektronikaussparung 33, ebenfalls ausgebildet als Durchgangsaussparung, umgeben von Seitenwänden 39. In diese Elektronikaussparung 33 ragt die Elektronik 41, insbesondere die Vergussmasse 44 mit den Elektronikbauteilen 43.

Die elektrisch leitende Verbindung zwischen Elektronikplatinenteil 42 und Sensorplatinenteil 24 erfolgt hier über eine Steckverbindung 27. Diese Steckverbindung 27 erstreckt sich ebenfalls in die Elektronikaussparung 33 des Halteelements 31.

Wie beispielsweise Figur 2 zeigt, ist die gesamte Elektrik 40 auf einer Seite des Sensors 20 angeordnet. Figur 2 zeigt hierzu eine Raumrichtung 26, die senkrecht zur Spulenachse 22 definiert ist und die Spulenachse 22 schneidet. Entlang dieser Raumrichtung 26 sind die Elektronik 41 und die Energiespeicher 45 angeordnet. Die Elektronik 41 befindet sich dabei zwischen den Energiespeichern 45 und dem Sensor 20.

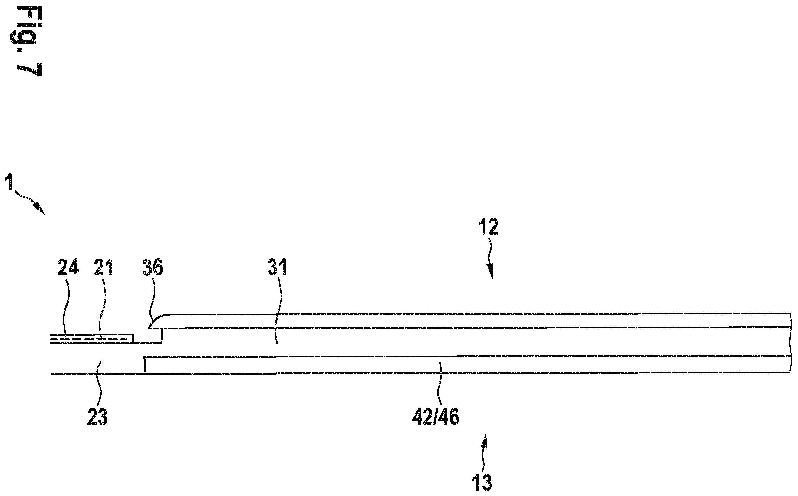

Figur 7 zeigt im Detail den Bereich zwischen Sensor 20 und Elektrik 40. Der Deckel 30 ist dabei ausgeblendet. Hierbei ist gut zu sehen, dass das Halteelement 31 an der Vorderseite 12 eine Halteelementkrempe 36 aufweist. Diese Halteelementkrempe 36 umgibt die Elektrik 40, insbesondere die Elektronikaussparung 33 und die Energiespeicheraufnahmen 32. Auf die Haltelementkrempe 36 kann der Deckel 30, insbesondere in einer elastischen Ausgestaltung, beispielsweise aus Silikon, aufgesteckt werden. Die Ränder des Deckels 30 umgreifen im aufgesteckten Zustand die Halteelementkrempe 36.

Der Deckel 30 und der Sensorplatinenteil 34 bilden somit die Außenseite und somit auch das Gehäuse der Sensorvorrichtung 1 auf der Vorderseite 12.

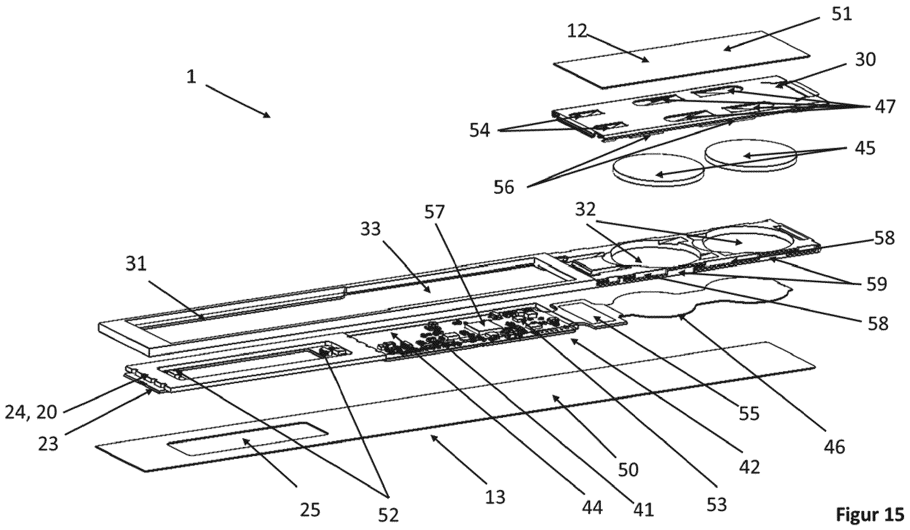

Die Rückseite 13, somit die Montagefläche der Sensorvorrichtung 1, ist durch ein in Figur 15 dargestelltes Klebelement 50 ausgebildet. Das Klebeelement 50 ist ebenfalls in der Variante der Figuren 2 bis 9 vorhanden. Das Sockelelement 23 und die Außenseite des Elektronikplatinenteils 42 und Speicherplatinenteils 46 sind stoffschlüssig mit dem Klebeelement 50 verbunden. Das Elektronikplatinenteil 42, das Speicherplatinenteil 46 und das Klebeelement 50 bilden zusammen einen rückwärtigen Gehäuseteil. Der Deckel 30 bildet ein vorderseitiges Gehäuseteil.

Figur 8 zeigt dieselbe Darstellung wie Figur 7, jedoch ohne Halteelement 31. Die beiden Figuren 7 und 8 verdeutlichen den Versatz zwischen Elektronikplatinenteil 42 und Spule(n) 21. In Figur 8 sind beispielhaft drei Spulen 21 eingezeichnet. In der gezeigten Variante sind alle Spulen (21) nicht nur versetzt, sondern weisen sogar einen Abstand 49 zum Elektronikplatinenteil 42 auf. Zum besseren Verständnis ist das Elektronikplatinenteil 42 bis unter das Sensorplatinenteil 24 hypothethisch verlängert dargestellt, obwohl unter dem Sensorplatinenteil 24 korrekterweise das Sockelelement 23 befindet.

Figur 8 zeigt ferner einen Spulenbereich 28, in dem sich die drei Spulen 21 befinden. Dieser Spulenbereich 28 ist insbesondere Bestandteil des Sensorplatinenteils 24. Der Spulenbereich 28 erstreckt sich vom oberen Ende der obersten Spule 21 bis zum untersten Ende der untersten Spule 21. Der Spulenbereich 28 weist parallel zur Spulenachse 22 eine erste Höhe 29 auf. Das Elektronikplatinenteil 42 erstreckt sich parallel zur Spulenachse 22 über eine zweite Höhe 48. Diese zweite Höhe 48 ist bevorzugt kleiner als die erste Höhe 29.

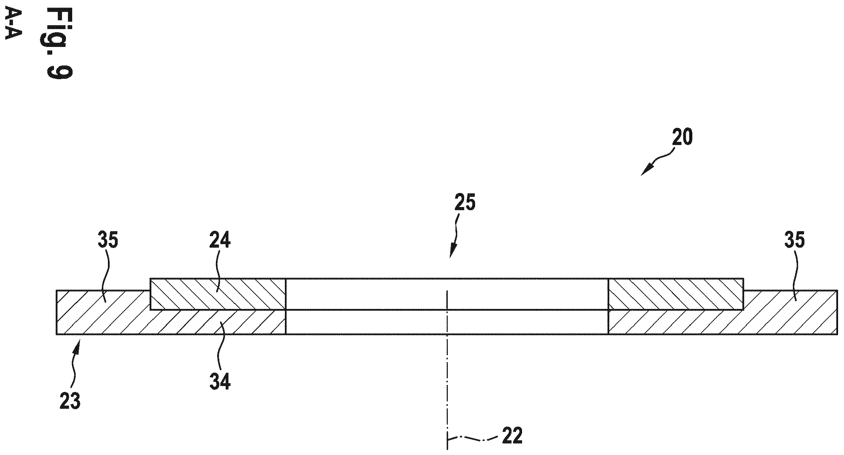

Figur 9 verdeutlicht den in Figur 2 gekennzeichneten Schnitt A:A. An dieser Darstellung ist der genaue Aufbau des Sockelelements 23 gut zu erkennen. Das Sockelelement 23 umfasst demgemäß die Sockelplatte 34 zur Aufnahme des Sensorplatinenteils 24. Seitlich des Sensorplatinenteils 24 sind zwei Seitenschienen 35 des Sockelelements 23 zur formschlüssigen Aufnahme des Sensorplatinenteils 34 angeordnet.

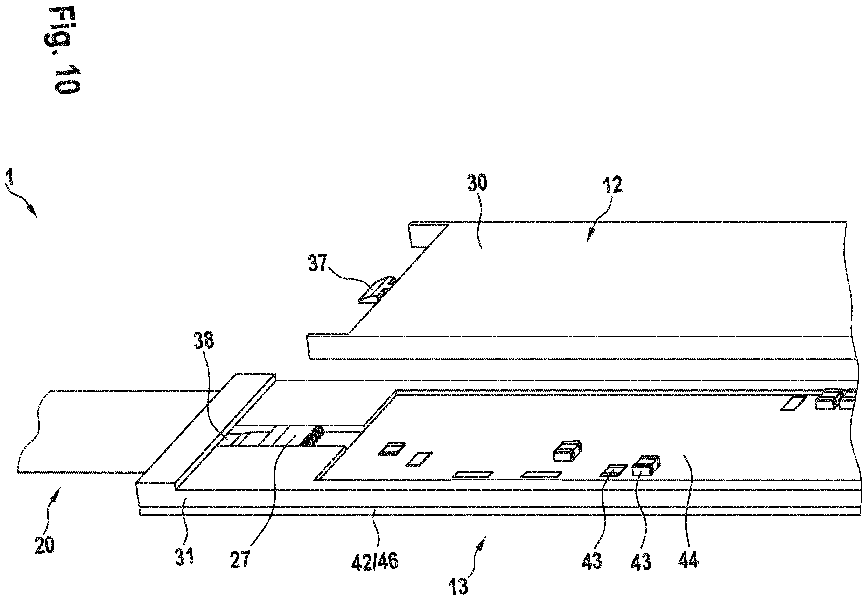

Figur 10 zeigt eine Variante der Sensorvorrichtung 1. Der grundsätzliche Aufbau der Sensorvorrichtung 1 ist hier wie in den Figuren 2 bis 9 beschrieben. Lediglich der Deckel 30 und seine Verbindung mit dem Halteelement 31 ist hier anders ausgestaltet. Der Deckel gemäß Figur 10 wird senkrecht zur Spulenachse 22 entgegen der Raumrichtung 26 auf das Halteelement 31 aufgeschoben. Der Deckel 30 weist eine Rastzunge 37 auf. Im Halteelement 31 ist eine Zungenaufnahme 38 ausgebildet. Im geschlossenen Zustand rastet die Rastzunge 37 in die Zungenaufnahme 38 ein.

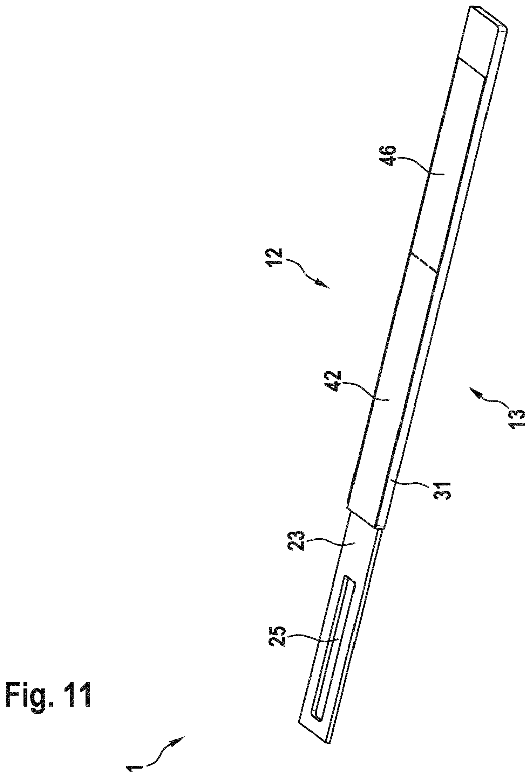

Die Figuren 11 bis 14 zeigen eine Variante der Sensorvorrichtung 1, bei der nicht das rückseitige Gehäuseteil mittels des Elektronikplatinenteils 42 und Speicherplatinenteils 46, sondern das vorderseitige Gehäuseteil durch diese Elemente gebildet wird. Demgemäß fungieren hier die beiden Platinenteile 42, 46 auch als Deckel und bilden insofern einen Teil des Gehäuses.

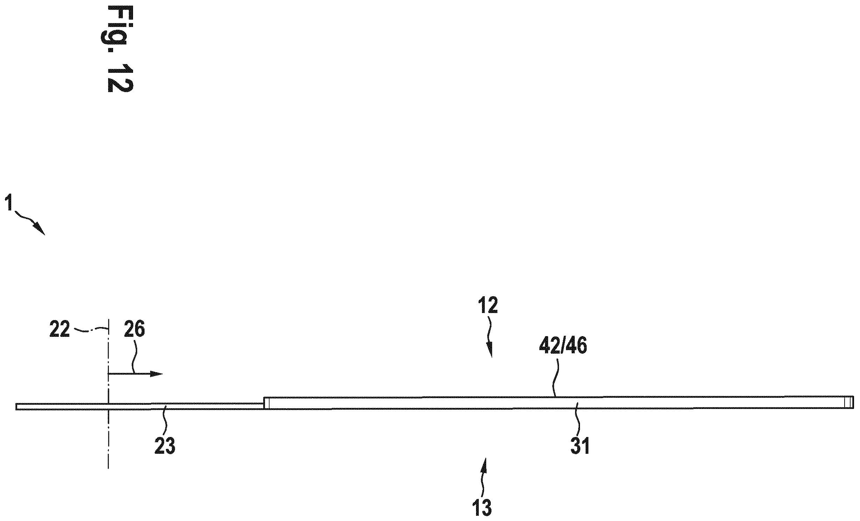

Figuren 11 und 12 zeigen die geschlossene Sensorvorrichtung 1. Das Sensorplatinenteil 24 ist hier wie in den vorhergehenden Varianten ausgestaltet, der Übersichtlichkeit halber jedoch nicht gezeigt.

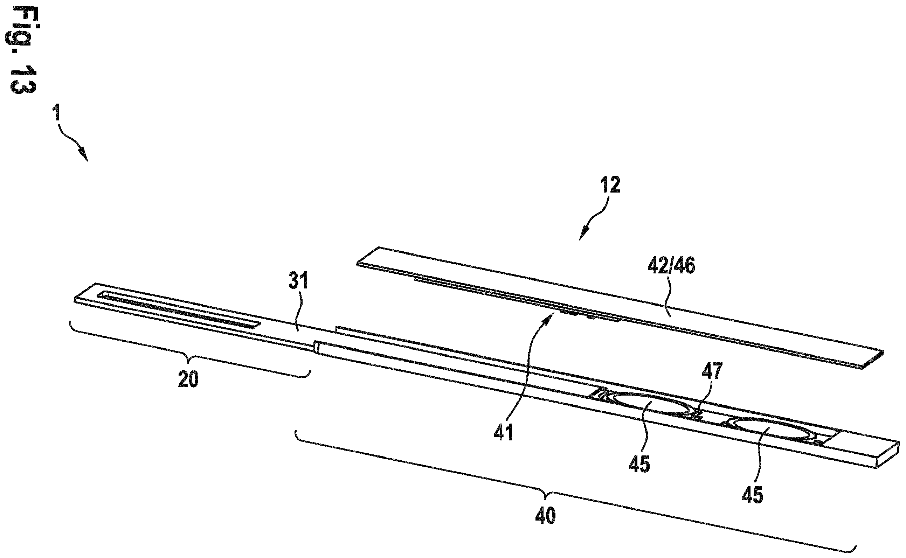

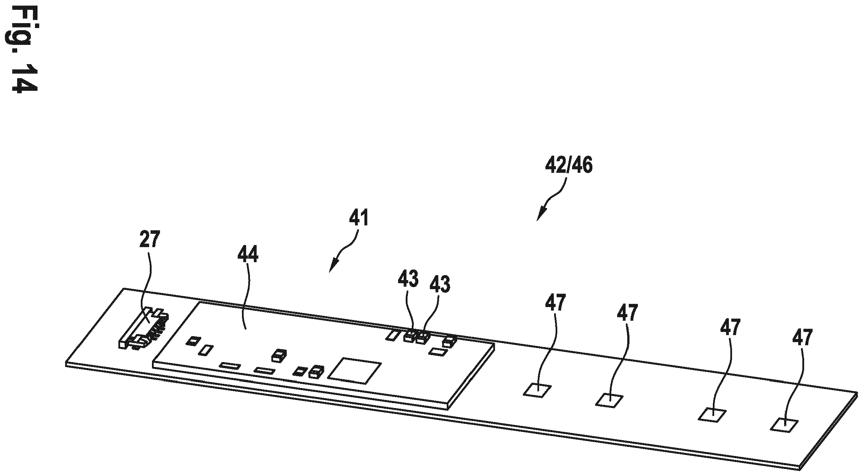

Figur 13 zeigt eine Explosionsdarstellung. Figur 14 zeigt lediglich die Innenseite des Elektronikplatinenteils 42 und Speicherplatinenteils 46, auch hier in einer einstückigen Ausgestaltung.

In der Variante gemäß den Figuren 11 bis 14 bildet die Außenseite des Haltelements 31 zusammen mit dem Klebelement 50 (nicht dargestellt) ein rückseitiges Gehäuseteil. Auch hier ist das Haltelement 31 einstückig mit dem Sockelelement 32 ausgebildet. Das Klebeelement 50 bildet die Rückseite 13.

An der Vorderseite 12 wird das Haltelement 31 durch das Elektronikplatinenteil 42 und das Speicherplatinenteils 46 verschlossen. Die außenliegende Seite dieser Platinenteile 42, 46 bildet somit das vorderseitige Gehäuseteil der Sensorvorrichtung auf der Vorderseite 12.

Die beiden Energiespeicher 45 werden hier in das Haltelement 31 eingesetzt. Wie insbesondere Figur 14 zeigt, befinden sich auf dem Speicherplatinenteil 46 entsprechende Energiespeicherkontakte 47. Diese Energiespeicherkontakte 47 können im zusammengebauten Zustand der Sensorvorrichtung 1 die Energiespeicher 45 direkt oder indirekt kontaktieren. Für die indirekte Kontaktierung befinden sich im Haltelement 31 ebenfalls Energiespeicherkontakte 47, die den elektrisch leitenden Kontakt zwischen Speicherplatinenteil 46 und Energiespeicher 45 herstellen.

Wie Figur 14 ebenfalls zeigt, befindet sich die Elektronik 41 mit Elektronikbauteilen 43 und Vergussmasse 44 auf der Innenseite des Elektronikplatinenteils 42.

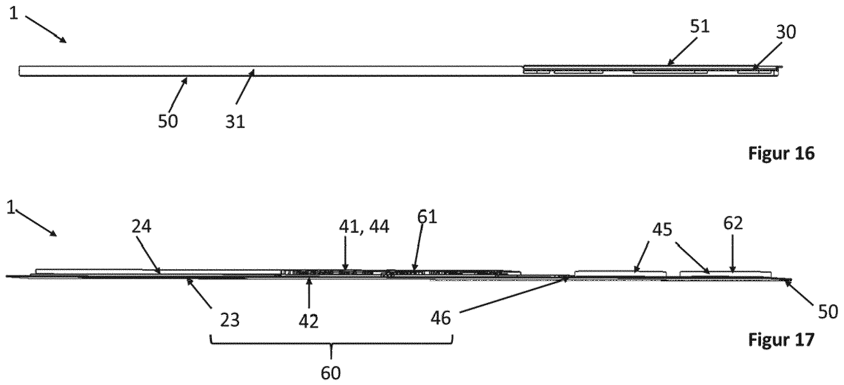

Figur 15 zeigt ein viertes Ausführungsbeispiel einer erfindungsgemäßen Sensorvorrichtung 1 in einer Explosionsdarstellung. Figur 16 zeigt das vierte Ausführungsbeispiel in einer Seitenansicht. Figur 17 zeigt die Ansicht aus Figur 16, wobei der Deckel 30, eine Folie 51 und das Halteelement 31 entfernt wurden. Im Folgenden insbesondere die Gemeinsamkeiten und die Unterschiede zu dem ersten Ausführungsbeispiel der Figuren 2-9 erläutert.

Die Sensorvorrichtung 1 umfasst ein Klebeelement 50, das wie in den ersten drei Ausführungsbeispielen die Rückseite 13 der Sensorvorrichtung 1 bildet. Eine Platine 60 ist einstückig und stoffschlüssig mit dem Klebeelement 50 verbunden.

Die Platine 60 umfasst das Speicherplatinenteil 46 und das Elektronikplatinenteil 42. Das Speicherplatinenteil 46 und das Elektronikplatinenteil 42 sind somit einstückig und materialeinheitlich ausgebildet. Hierbei ist die Platine 60 an dem Klebeelement 50 angeklebt.

Ferner ist das Sockelelement 23 einstückig und materialeinheitlich mit dem Elektronikplatinenteil 42 und dem Speicherplatinenteil 46 ausgebildet. Somit wird die Platine 60 aus dem Sockelelement 23, dem Elektronikplatinenteil 42 und dem Speicherplatinenteil 42 gebildet. Die Platine 60 ist über die gesamte Länge L gleichbleibend hoch ausgebildet. Somit sind das Sockelelement 23, das Elektronikplatinenteil 42 und das Speicherplatinenteil 42 in Richtung der Spulenachse 22 gleichbleibend hoch ausgebildet.

Auf dem Sockelelement 23 ist das Sensorplatinenteil 24 angeordnet. Das Sensorplatinenteil 24 ist stoffschlüssig mit der Sockelplatte 23 verbunden, insbesondere angelötet. Das Sensorplatinenteil 24 enthält die Spulen 21, wobei zumindest ein oder zwei Sendespule(n) 21 zwischen zwei Empfangsspulen 21 innerhalb des Sensorplatinenteils 24 angeordnet sind. Hierbei sind die Empfangs- und Sendespulen 21 mit derselben oder parallelen Spulenachsen 22 ausgebildet.

Die Spulen 21 sind elektrisch und stoffschlüssig mit dem Sockelelement 23 verbunden, insbesondere angelötet. Über das Sockelelement 23 sind die Spulen 21 elektrisch mit der Elektrik 40, d. h der Elektronik 41 und den Energiespeichern 45, verbunden.

Zugleich beanstandet das Sockelelement 23 die Spulen 21 von der Rückseite 13 der Sensorvorrichtung 1. Das Sockelelement 23 ist als Teil der Platine 60 ausgebildet. Somit versetzt das Sockelelement 23 die Spulen 21 von dem Elektronikplatinenteil 42 und dem Speicherplatinenteil 46 in Richtung der Sensorachse 22.

Die Sensorvorrichtung 1 ist auf der Vorderseite 12 eben ausgebildet (s. Fig. 16). Mittels des Sockelelements 23 werden nicht nur die Spulen 21 von der Rückseite 13 beabstandet. Vielmehr gleicht das Sockelelement 23 auch einen Höhenunterschied zwischen dem Sensorplatinenteil 24 und einem Elektronikbereich 61 im Wesentlichen aus. Hierbei weist das Sensorplatinenteil 24 im Wesentlichen dieselbe Höhe wie die Vergussmasse 44 mit der Elektronik 41 auf. Ebenfalls gleicht das Sockelelement 23 einen Höhenunterschied zwischen dem Sensorplatinenteil 24 und einem Speicherbereich 62 im Wesentlichen aus. Hierbei weisen die Energiespeicher 45 im Wesentlichen dieselbe Höhe wie das Sensorplatinenteil 24 auf.

Eine Lichtschranke 52 ist innerhalb des Sensorplatinenteils 24 angeordnet. Mittels der Lichtschranke 52 kann die Stellung des Riegelelements 5 zusätzlich zu den als Spulen 21 ausgebildeten Sensors 20 detektiert werden. Es ist aber auch denkbar, dass vierte Ausführungsbeispiel ohne Lichtschranke 52 auszugestalten und die Betriebszustände nur mittels des Sensors 20 zu detektieren.

Das Halteelement 31 ist auf dem Klebelement 50 befestigt.

Das Halteelement 31 ist als ein Kunststoffrahmen ausgebildet. Das Halteelement 31 bildet die Elektronikaussparung 33 als Durchgangsöffnung aus, die als Wanne für die Vergussmasse 44 dient. Zudem umrahmt die Elektronikaussparung 33 auch den Sensor 20.

Das Halteelement 31 bildet die Energiespeicheraufnahme 32 als Durchgangsöffnung aus. Innerhalb der Energiespeicheraufnahme 32 sind die Energiespeicher 45 angeordnet. Auf dem Speicherplatinenteil 46 sind erste elektrische Energiespeicherkontakte (nicht dargestellt) für einen ersten Pol der Energiespeicher 45 ausgebildet. Elektrische Leitungselemente führen in oder auf dem Speicherplatinenteil 46 zu der Elektronik. An dem zweiten Pol der Energiespeicher 45 liegen Energiespeicherkontakte 47 an.

Anders als in dem Ausführungsbeispiel der Figuren 2-9, sind die zweiten Energiespeicherkontakte 47 als elastische Zungen eines Deckels 30 ausgebildet. Der Deckel 30 ist elektrisch leitend, insbesondere metallisch. Der Deckel 30 umfasst Kontaktzungen 54, so dass der elektrische Strom von dem zweiten Pol der Energiespeicher 45 über die zweiten Energiespeicherkontakte 47 zu den Kontaktzungen 54 fließen kann. Die Kontaktzungen 54 liegen federnd und elektrisch kontaktierend an einem Kontaktfeld 55 des Speicherplatinenteils 46 an. Von dem Kontaktfeld führen elektrische Leitungselemente in oder auf dem Speicherplatinenteil 46 zu der Elektronik.

Das Klebeelement 50, die Platine 60 und das Halteelement 31 bilden zusammen ein rückseitiges Gehäuseteil.

Dadurch, dass die zweiten Energiespeicherkontakte 47 und die Kontaktzungen 54 federnd ausgebildet sind und unter mechanischer Spannung an dem Energiespeicher 45 bzw. an dem Kontaktfeld 55 anliegen, ist der Stromfluss gewährleistet. Zudem drücken die zweiten Energiespeicherkontakte 47 die Energiespeicher 45 an die ersten Energiespeicherkontakte für den ersten Pol, so dass auch hier der Stromfluss gewährleistet ist. Somit dienen die zweiten Energiespeicherkontakte 47 als federnder Vorsprung.

Zur elektrischen Isolierung des Deckels 30 ist der Deckel 30 mit einer nicht leitenden Folie 51 stoffschlüssig verbunden, insbesondere beklebt. Die Folie 51 bildet einen Teil der Vorderseite 12 der Sensorvorrichtung 1. Die Folie 51 und der Deckel 30 bilden zusammen ein vorderseitiges Gehäuseteil.

Des Weiteren wird die Vorderseite 12 von der Vergussmasse 44 und dem Sensorplatinenteil 24 gebildet. Es ist alternativ und nicht dargestellt möglich, die Vergussmasse 44 und eventuell das Sensorplatinenteil 24 mit der Folie 51 zu bedecken. Hierdurch ist die Sende- und/oder Empfangseinheit 63 und der Sensor 20 mit der Vorderseite 12 und der Rückseite 13 stoffschlüssig verbunden. Im Bereich der Elektronik 41, d. h. im Elektronikbereich 61, und im Bereich des Sensors 20 ist die Sensorvorrichtung 1 gehäusefrei ausgebildet, d. h. Vorder- und Rückseite 12, 13 sind stoffschlüssig miteinander verbunden.

Der Deckel 30 wird an dem Halteelement 31 reversibel lösbar, insbesondere formschlüssig befestigt. Hierzu umfasst der Deckel 30 Verbindungselement 56, die durch Aussparungen 59 des Halteelements 31 geführt werden können. Danach wird durch Verschieben des Deckels 30 die Verbindungselemente 56 in Formschluss mit Vorsprüngen 58 des Halteelements 31 gebracht und damit befestigt. Die Verbindungselemente 56 und die Vorsprünge 58 sind derart ausgebildet, so dass die Energiespeicherkontakte 47 und die Kontaktzungen 54 bei geschlossenem Deckel mechanisch gespannt sind.

Bei den Ausführungsbeispielen der Figuren 2 bis 9 und 10 kann der Deckel 30 Vorsprünge aufweisen, die die Energiespeicher 45 gegen das Speicherplatinenteil drücken.

### Bezugszeichenliste

- 1: Sensorvorrichtung
- 2: Anordnung
- 3: Verschlusselement
- 4: Schloss
- 5: Riegelelement
- 6: weiteres Riegelelement
- 7: Stulp
- 8: Schließblech
- 9: Fallenöffnung
- 10: Riegelöffnung
- 11: Verschlusselementspalt
- 12: Vorderseite
- 13: Rückseite

- 20: Sensor
- 21: Spule
- 22: Spulenachse
- 23: Sockelelement
- 24: Sensorplatinenteil
- 25: Durchgangsaussparung
- 26: Raumrichtung
- 27: Steckverbindung
- 28: Spulenbereich
- 29: erste Höhe

- 30: Deckel
- 31: Halteelement
- 32: Energiespeicheraufnahme
- 33: Elektronikaussparung
- 34: Sockelplatte
- 35: Seitenschienen
- 36: Haltelementkrempe
- 37: Rastzunge
- 38: Zungenaufnahme
- 39: Seitenwände

- 40: Elektrik
- 41: Elektronik
- 42: Elektronikplatinenteil
- 43: Elektronikbauteile
- 44: Vergussmasse
- 45: Energiespeicher
- 46: Speicherplatinenteil
- 47: Energiespeicherkontakte
- 48: zweite Höhe
- 49: Abstand

- 50: Klebeelement
- 51: Folie
- 52: Lichtschranke
- 53: Beschleunigungssensor
- 54: Kontaktzungen
- 55: Kontaktfeld
- 56: Verbindungselemente
- 57: Steuereinheit
- 58: Vorsprung
- 59: Aussparung
- 60: Platine
- 61: Elektronikbereich
- 62: Speicherbereich

## Patentansprüche

1. Sensorvorrichtung (1) für ein Verschlusselement (3), insbesondere eine Tür oder ein Fenster,
• mit einem Sensor (20),
• mit einer Elektrik (40) zur Stromversorgung und/oder Ansteuerung des Sensors (20),
• mit einer Vorderseite (12) und mit einer gegenüberliegenden Rückseite (13), wobei zumindest ein Teil der Rückseite (13) als Montagefläche zur Montage der Sensorvorrichtung (1) am Verschlusselement (3) ausgebildet ist,
**dadurch gekennzeichnet,**
**dass** die Elektrik (40) zumindest teilweise stoffschlüssig mit der Vorderseite (12) und/oder mit der Rückseite (13) verbunden ist.

2. Sensorvorrichtung nach Anspruch 1, wobei
• die Elektrik (40) eine Elektronik (41), insbesondere eine Sende- und Empfangseinheit und/oder einen Prozessor, umfasst und die Sensorvorrichtung (1) vorzugsweise ein Elektronikplatinenteil (42) umfasst, auf dem die Elektronik (41) angeordnet ist,
• und/oder die Elektrik (40) zumindest einen elektrischen Energiespeicherkontakt zur Kontaktierung eines Energiespeicher (45) umfasst und die Sensorvorrichtung (1) vorzugsweise ein Speicherplatinenteil (46) umfasst, das den elektrischen Energiespeicherkontakt umfasst,
• und/oder die Sensorvorrichtung (1) ein Sensorplatinenteil (24) umfasst, das den Sensor (20) aufnimmt, wobei der Sensor (20) vorzugsweise in und/oder auf dem Sensorplatinenteil (24) angeordnet ist.

3. Sensorvorrichtung nach Anspruch 2, **dadurch gekennzeichnet, dass** das Speicherplatinenteil (46) zumindest einen Teil eines Gehäuses der Sensorvorrichtung (1) bildet, wobei das Speicherplatinenteil (46) vorzugsweise reversibel lösbar von einem weiteren Teil des Gehäuses derart ausgebildet ist, sodass der Energiespeicher (45) austauschbar ist.

4. Sensorvorrichtung nach einem der Ansprüche 2 oder 3, **dadurch gekennzeichnet, dass** das Sensorplatinenteil (24), das Speicherplatinenteil und/oder das Elektronikplatinenteil stoffschlüssig mit der Vorderseite (12) und/oder mit der Rückseite (13) verbunden ist.

5. Sensorvorrichtung nach einem der vorhergehenden Ansprüche, **dadurch gekennzeichnet, dass** Seitenwände (39) der Sensorvorrichtung von einem Halteelement (31), insbesondere aus Kunststoff, gebildet ist.

6. Sensorvorrichtung nach einem der vorhergehenden Ansprüche, **dadurch gekennzeichnet, dass** das Halteelement (31) einstückig mit dem Speicherplatinenteil (46) und/oder dem Elektronikplatinenteil (42) ausgebildet ist, wobei das Halteelement (31) insbesondere über ein Klebeelement (50) und/oder eine Vergussmasse (44) mit dem Speicherplatinenteil (46) und/oder dem Elektronikplatinenteil (42) verbunden ist.

7. Sensorvorrichtung nach einem der vorhergehenden Ansprüche, **dadurch gekennzeichnet, dass** ein Sockelelement (23) das Sensorplatinenteil (24) von der Rückseite (13) beabstandet, insbesondere dass das Sockelelement (23) einstückig mit dem Halteelement (31) oder mit dem Elektronikplatinenteil (42) ausgebildet ist.

8. Sensorvorrichtung nach einem der vorhergehenden Ansprüche, **dadurch gekennzeichnet, dass** das Halteelement (31) das Speicherplatinenteil (46) zumindest teilweise umgibt.

9. Sensorvorrichtung nach einem der Ansprüche 2 bis 8, **dadurch gekennzeichnet, dass** das Speicherplatinenteil (46) und das Elektronikplatinenteil (42) miteinander einstückig ausgebildet sind und eine gemeinsame Platine (60) bilden, wobei insbesondere der Energiespeicher (45) und die Elektronik (41) auf derselben Seite der Platine (60) angeordnet sind.

10. Sensorvorrichtung nach einem der vorhergehenden Ansprüche, **dadurch gekennzeichnet, dass** die Sensorvorrichtung (1) zur Anordnung in einem Verschlusselementspalt (11) ausgebildet ist, wobei die Sensorvorrichtung eine Höhe von höchstens 2,5 mm, bevorzugt höchstens 2,3 mm, besonders bevorzugt höchstens 2,1 mm, aufweist und/oder dazu ausgebildet ist, mit einem Klebeelement (50) an dem Verschlusselement (3), insbesondere einem Verschlusselementblatt, befestigt zu werden.

11. Sensorvorrichtung nach einem der Ansprüche 5 bis 10, **dadurch gekennzeichnet, dass** das Halteelement (31) eine Elektronikaussparung (33) aufweist und dadurch die Elektronik (41), insbesondere die Sende- und Empfangseinheit und/oder den Prozessor, zumindest teilweise umgibt, wobei in der Elektronikaussparung (33) vorzugsweise auch eine die Elektronik (41) zumindest teilweise umgebende Vergussmasse (44) angeordnet ist.

12. Sensorvorrichtung nach einem der Ansprüche 5 bis 11, **dadurch gekennzeichnet, dass** das Halteelement (31), insbesondere mit einer Energiespeicheraufnahme (32), als Befestigung für den Energiespeicher (45) dient, wobei vorzugsweise ein als Feder ausgebildeter Energiespeicherkontakt (47) den Energiespeicher (45) gegen das Halteelement (31) und/oder gegen das Speicherplatinenteil (46) presst.

13. Sensorvorrichtung nach einem der Ansprüche 2 bis 12, **dadurch gekennzeichnet, dass** die Rückseite (13) von einem Klebeelement (50) gebildet ist, wobei das rückseitige Gehäuse das Speicherplatinenteil (46) und das Klebeelement (50) umfasst.

14. Sensorvorrichtung nach einem der vorhergehenden Ansprüche, **dadurch gekennzeichnet, dass** ein Deckel (30) des Gehäuses, der vorgesehen ist, ein vorderseitiges Gehäuseteil zumindest teilweise zu bilden, reversibel lösbar von einem weiteren Gehäuseteil, insbesondere von einem rückseitigen Gehäuseteil, ausgebildet ist, insbesondere auf das übrige Gehäuse aufschiebbar oder überstülpbar ausgebildet ist.

15. Sensorvorrichtung nach einem der vorhergehenden Ansprüche, **dadurch gekennzeichnet, dass** der Deckel (30) zumindest einen federnden Vorsprung (47) umfasst, um den Energiespeicher (45) gegen das Speicherplatinenteil (46) zu drücken.
